## Europäisches Patentamt
## European Patent Office
## Office européen des brevets

(11) Publication number: **0 056 128**
**B1**

# EUROPEAN PATENT SPECIFICATION

(45) Date of publication of patent specification: **17.04.85**

(21) Application number: **81110507.1**

(22) Date of filing: **16.12.81**

(51) Int. Cl.⁴: **H 03 L 7/18,** H 04 N 5/93, G 11 B 5/86

(54) **Phase synchronizing circuit.**

(30) Priority: **14.01.81 JP 4334/81**

(43) Date of publication of application: **21.07.82 Bulletin 82/29**

(45) Publication of the grant of the patent: **17.04.85 Bulletin 85/16**

(84) Designated Contracting States: **DE FR GB IT NL**

(56) References cited:
GB-A-2 033 178
US-A-3 887 941
US-A-3 900 890
US-A-4 115 786

NACHRICHTENTECHNISCHE ZEITSCHRIFT, vol. 31, no. 3, March 1978, pages 207-209, Berlin, DE. R. KLINGER: "Frequenzaufbereitung für mobile und tragbare Funkgeräte mit quarzsparenden Schaltungen"
IEEE TRANSACTIONS ON SPACE ELECTRONICS AND TELEMETRY, SET-9, no. 2, June 1963, pages 57-60 New York, USA A.G. RATZ et al.: "Automatic tape-editing equipment"

(73) Proprietor: **Kabushiki Kaisha Toshiba 72, Horikawa-cho Saiwai-ku Kawasaki-shi Kanagawa-ken 210 (JP)**

(72) Inventor: **Nagumo, Masahide 38 Ogura Saiwai-ku Kawasaki-shi (JP)**
Inventor: **Kojima, Tadashi 6-20, Kugo-cho Yokosuka-shi Kanagawa-ken (JP)**

(74) Representative: **Blumbach Weser Bergen Kramer Zwirner Hoffmann Patentanwälte Radeckestrasse 43 D-8000 München 60 (DE)**

## Description

The present invention relates to a phase synchronizing circuit for obtaining first and second clock signals whoses phases are synchronized with each other provided with a phase locked loop including a first phase comparison circuit, a voltage controlled oscillator (VCO) for producing an oscillation output the frequency of which is controlled by the output of said first phase comparison circuit, first frequency dividing means having at least a first frequency divider to divide the frequency of oscillation output of said VCO wherein a predetermined input signal is supplied to said first phase comparison circuit and second frequency dividing means for dividing the output frequency of said VCO.

In the case of conventional analog tape recorders, for example, changes in the amplitude of signals such as audio signals which represent analog data are converted to those in the strength of magnetic field and the changes in the strength are recorded on a tape in the running direction thereof. Therefore, the performance of head, tape and the like gives influence to the dynamic range, distortion factor, and the like of the audio signals. Namely, the performance of tape running system gives influence to the frequency characteristics of the audio signals, wow, fluttering phenomenon, introduced noise and the like, and the audio signals are modulated by the fluctuation of tape speed and the like. Therefore, audio information analogically recorded is degraded in tone quality every time when it is copied.

A phase synchronizing circuit in accordance with prior art portion of claim 1 is known from US—A—3 887 941. This reference describes a synchronizing pulse processor adapted to adjust a phase relation between a horizontal synchronizing signal and a vertical synchronizing signal when editing is effected on a recording medium of a VTR (video tape recorder). The prior art circuit can synchronize the phase of a first clock signal with that of a second clock signal when the digital data of one recording medium is copied on another recording medium. The prior art device is adapted to process a synchronizing pulse of a video tape recorder. The data treated by the prior art device are in the form of analog data.

There has been developed these days a system which records audio signals as digital data and reproduces the recorded digital data. This system samples audio signals at a predetermined sampling frequency and quantizes the amplitude of sampled audio signals, thus recording audio signals at digital data on the tape, for example. Therefore, if it can be determined exactly that the logical level of information recorded on the tape is "0" or "1" when records on the tape are reproduced, analog waveforms before recorded will be restored completely. Generally, the recording medium on which digital data are recorded is sometimes deformed after it is used many times. In addition, error and the like are sometimes caused on recorded contents. Accordingly, recorded contents must be sometimes copied on a new recording medium. The reproducing device which copies digital data has usually error correcting function, thus allowing error-corrected digital data to be copied on the new recording medium. Therefore, different from the copying of analog data, even an audio signal of low frequency can be restored without being influenced by the speed fluctuation, wow, flutter and the like of reproducing system.

In the case of copying digital data on another recording medium, digital data are transferred between reproducing section and recording section. It is therefore necessary that the reproducing section is completely synchronized with the recording section. Namely, a clock signal employed in the reproducing section and a clock signal employed in the recording section must be synchronized in their phases.

The object of the present invention is to provide a phase synchronizing circuit for permitting the phase of a first clock signal of a reproducing device to be synchronized with the phase of a second clock signal of a recording device when digital data of one recording medium is copied on another. It is intended to synchronize the phase of the first clock signal with that of the second clock signal with a higher accuracy than in the prior art device.

In order to achieve this object, a phase synchronizing circuit of the type mentioned above is characterized in that said phase synchronizing circuit includes a second phase comparison circuit for receiving, as inputs, the first clock signal which is an output from said first frequency dividing means and said second clock signal which is an output from said second frequency dividing means, to compare phases of said first and second clock signals; and frequency dividing ratio controlling means for controlling said first frequency divider and second phase comparison circuit in such a way that the frequency dividing ratio of said first divider is changed to one of three stages of $1/N$, $1/(N+1)$ and $1/\{[N+(N+1)]/2\}$ (wherein N is a positive integer) according to the phase difference between said first and second clock signals so as to synchronize phases of said first and second clock signals.

This invention can be more fully understood from the following detailed description when taken in conjunction with the accompanying drawings, in which:

Fig. 1 is a block diagram showing an embodiment of the present invention.

Fig. 2 is a circuit diagram of first frequency divider and second phase comparator shown in Fig. 1.

Fig. 3 shows the internal arrangement of a shift register SR1 shown in Fig. 2.

Fig. 4A shows signal waveforms in the first frequency divider shown in Fig. 2 at the first frequency dividing mode of a first frequency divider circuit shown in Fig. 1.

Fig. 4B shows signal waveforms in the first frequency divider shown in Fig. 2 at the second frequency dividing mode.

Fig. 4C shows signal waveforms in the first frequency divider shown in Fig. 2 at the third frequency dividing mode.

Fig. 5 is a chart for illustrating the phase difference between first and second clock signals shown in Fig. 1.

Figs. 6A—6C are timing charts to explain the operation of circuit shown in Fig. 2.

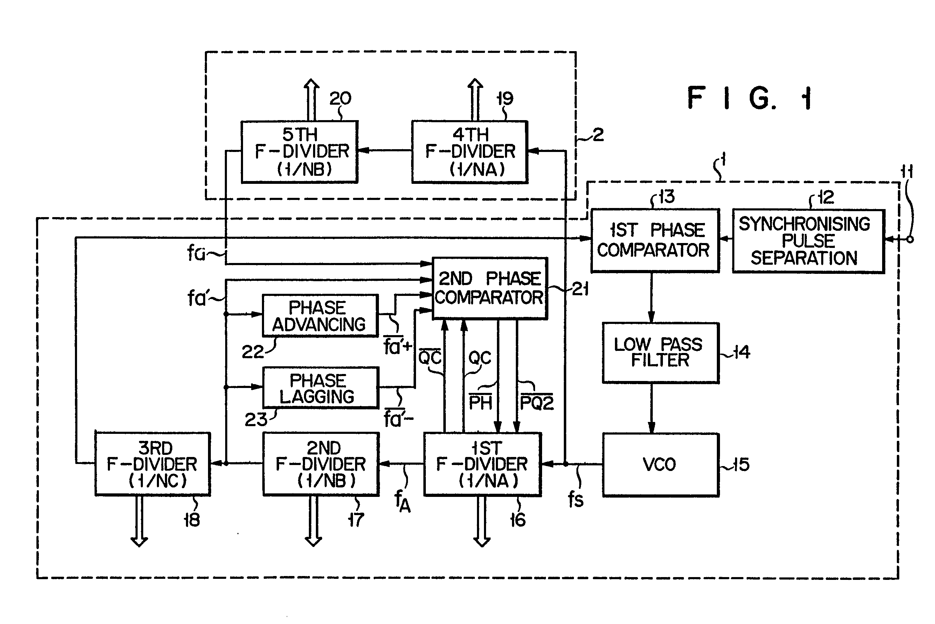

In Fig. 1, numeral 1 represents digital data reproducing section and 2 digital data recording section for recording the digital data reproduced. Data reproducing and recording circuits in digital data reproducing and recording sections are omitted and only a phase synchronizing circuit for clock pulses employed in the data reproducing and recording sections is shown in Fig. 1.

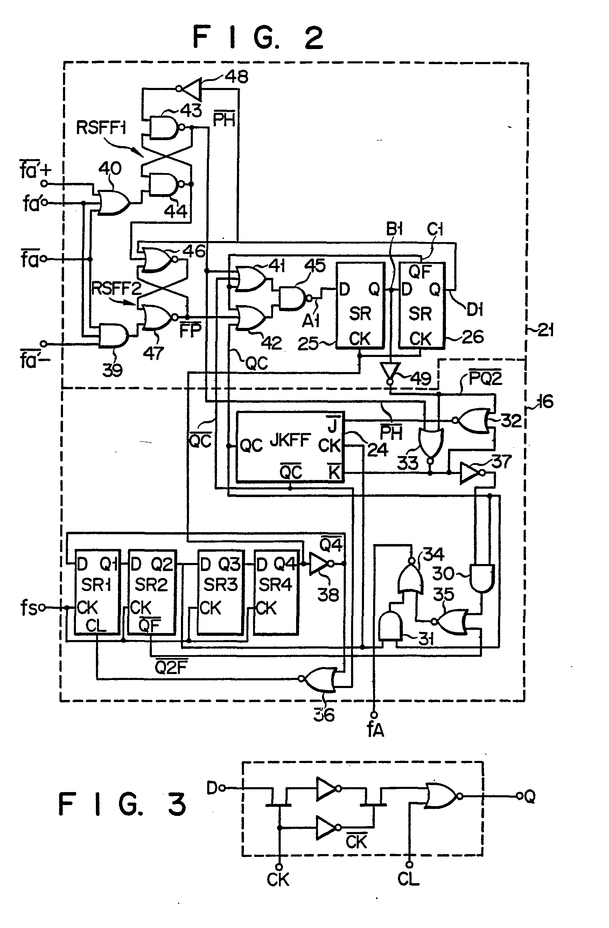

Numeral 11 denotes an input terminal to which reproduced signals from a digital data recording medium (not shown) are applied. Digitized audio and synchronizing signals, for example, are recorded on this recording medium. These synchronizing signals are separated from a reproduced TV format signal by a synchronizing signal separation circuit 12 to be supplied to a first phase comparison circuit 13. An output of the first phase comparison circuit 13 is fed back to the first phase comparison circuit 13 via a low pass filter 14, a voltage controlled oscillator (VCO), a first frequency divider circuit 16 whose frequency dividing ratio is 1/NA, a second frequency divider circuit 17 whose frequency dividing ratio is 1/NB, and a third frequency divider circuit 18 whose frequency dividing ratio is 1/NC. The first phase comparison circuit 13, low pass filter 14, VCO 15, first, second and third frequency divider. circuits form a phase locked loop (PLL). The VCO circuit 15 outputs an oscillation output or oscillation signal $f_s$ having a constant frequency. In the recording section 2, are arranged a fourth frequency divider circuit 19 for dividing the oscillation signal $f_s$ of VCO 15 by NA, and a fifth frequency divider circuit 20 for dividing the output frequency of the divider circuit 19 by NB to produce a clock signal $f_a$. It is assumed that the output of the second frequency divider circuit 17 is a first clock signal $f_a'$ and that the output of fifth frequency divider circuit 20 is a second clock signal $f_a$. Clock signals for the reproducing circuit whose detail is not shown are obtained through each of first, second and third frequency divider circuits and clock signals for the recording circuit which is not shown are obtained through each of fourth and fifth frequency divider circuits. A second phase comparison circuit 21 is arranged to compare the phase of first clock signal $f_a'$ with that of second clock signal $f_a$. Input terminals of a phase advancing circuit 22 and a phase lagging circuit 23 are connected to the output terminal of second frequency divider circuit 17, the phase advancing circuit 22 serving to produce an output signal $\overline{f_a'}_+$ whose phase is advanced by a predetermined angle relative to the first clock signal $f_a'$ and the phase lagging circuit 23 serving to produce an output signal $\overline{f_a'}_-$ whose phase is lagged by same angle relative to the first clock signal $f_a'$. To the second phase comparison circuit 21 are supplied the first clock signal $f_a'$, second clock signal $f_a'$ output $\overline{f_a'}_+$ of the phase advancing circuit 22, output $\overline{f_a'}_-$ of phase lagging circuit 23, and signals Qc and $\overline{Qc}$ from first frequency divider circuit 16 which will be described later. Signals $\overline{PH}$ and $\overline{PQ_2}$ obtained as comparison results are supplied from the comparison circuit 21 to the first frequency divider circuit 16. Levels of outputs $\overline{PH}$ and $\overline{PQ_2}$ of second phase circuit 21 change according to the phase difference of first and second clock signals $f_a'$ and $f_a$, and the frequency dividing ratio of first divider circuit 16 changes according to the level change, thus allowing the phase of first clock signal to be accorded with that of second clock signal. The first frequency divider circuit 16, at first and then, the second phase comparison circuit 21 will be now described in detail referring to Fig. 2.

The oscillation signal $f_s$ of VCO 15 is supplied to CK terminals of first, second, third and fourth shift registers SR1, SR2, SR3 and SR4. The arrangement of each of shift registers SR1, SR3 and SR4 is shown in Fig. 3. A $\overline{QF}$ terminal is arranged in the shift register SR2 to produce an output having a phase advanced only by half cycle of $f_s$ relative to the phase of an output on a terminal $Q_2$. This frequency divider circuit 16 includes shift registers SR1—SR4, a JKFF (JK flip-flop) 24, AND gates 30, 31, NOR gates 32—36, and inverters 37, 38. The second phase comparison circuit 21 includes an AND gate 39, OR gates 40, 41, 42, NAND gates 43, 44, 45, NOR gates 46, 47, inverters 48, 49, and shift registers 25, 26. NAND gates 43 and 44 form a set-reset flip-flop $RSFF_1$ and NOR gates 46 and 47 a set-reset flip-flop $RSFF_2$. To the OR gate 40 are supplied the output signal $\overline{f_a'}_+$ of the phase advancing circuit 22, first clock signal $f_a'$ and an inverted signal $\overline{f_a}$ of second clock signal $f_a$. To the AND gate 39 are supplied an inverted signal $\overline{f_a}$ of second clock signal $f_a$, the first clock signal $f_a'$ and output signal $\overline{f_a'}_-$ of phase lagging circuit 23. A divided output $f_A$ is obtained through the NOR gate 34 in the first frequency divider circuit 16. Relative connections among the AND gates, OR gates, NAND gates, NOR gates and inverters and those among shift registers SR1—SR4, 25, 26, and JKFF 24 are as shown in Fig. 2 and description among these connections is therefore omitted.

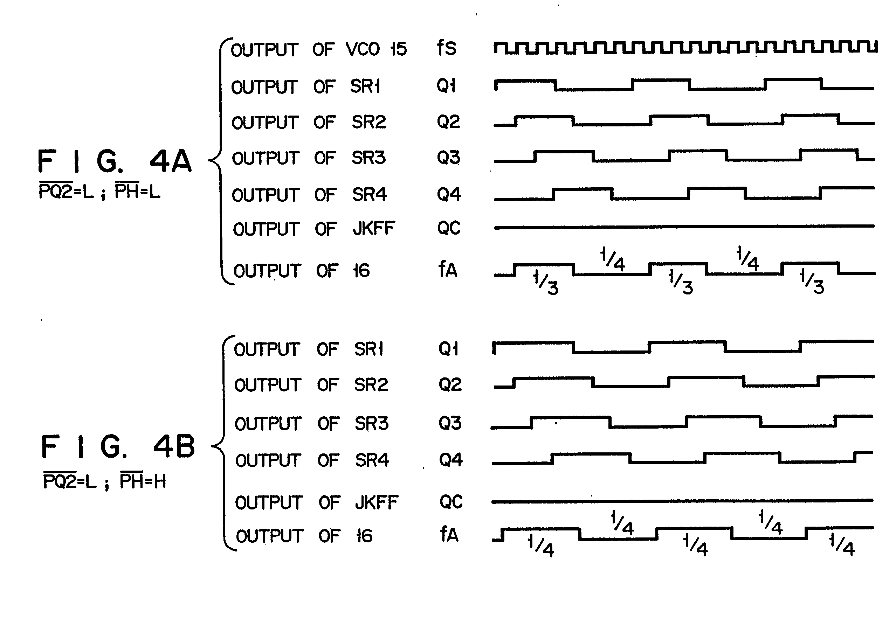

Operation of first frequency divider circuit 16 shown in Fig. 2 will be now described referring to Figs. 4A—4C. It is assumed that the oscillation signal $f_s$ of VCO 15 shown in Fig. 1 has such a frequency as shown in Fig. 4A. It is also assumed that signals $\overline{PH}$ (output of $RSFF_1$) and $\overline{PQ_2}$ (output of inverter 49) for controlling the frequency dividing ratio of first divider circuit 16 are of "L" level at the same time. Then, a $\overline{J}$ input terminal of JKFF 24 becomes "L" level and a $\overline{K}$ input terminal thereof "H" level. A first output terminal QC of JKFF 24 then becomes "H" level as shown in Fig. 4A. Therefore, a second output terminal $\overline{QC}$ of

JKFF 24 becomes "L" level. Levels of output voltages appearing at output terminals $Q_1$—$Q_4$ of shift registers SR1—SR4 change as shown in Fig. 4A, respectively. Every time when an output terminal $Q_4$ of shift register SR4 becomes "H" level, a clear signal is applied to a clear terminal CL of shift register SR1 through the inverter 38 and NOR gate 36. Therefore, the output signal $f_A$ of first frequency divider circuit 16 becomes a signal having a frequency in which the oscillation signal $f_s$ is divided to 1/7. Numerals 1/3 and 1/4 annexed to the signal waveform $F_A$ represent frequency dividing ratios, that is, time periods which are three and four times the cycle of signal $f_s$, respectively.

It is assumed that the signal $\overline{PQ_2}$ (output of inverter 49) is of "L" level and the signal $\overline{PH}$ (output of $RSFF_1$) is of "H" level as shown in Fig. 4B. This time, the $\overline{J}$ terminal of JKFF 24 becomes "H" level and the $\overline{K}$ terminal "L" level, so that the first output terminal $Qc$ of JKFF 24 becomes "L" level and the second output terminal $\overline{Qc}$ thereof "H" level. Therefore, no clear signal is applied to the CL terminal (or clear terminal) of shift register SR1. The output signal of first frequency divider circuit 16 therefore becomes a signal having a frequency in which the oscillation signal $f_s$ is divided to 1/8.

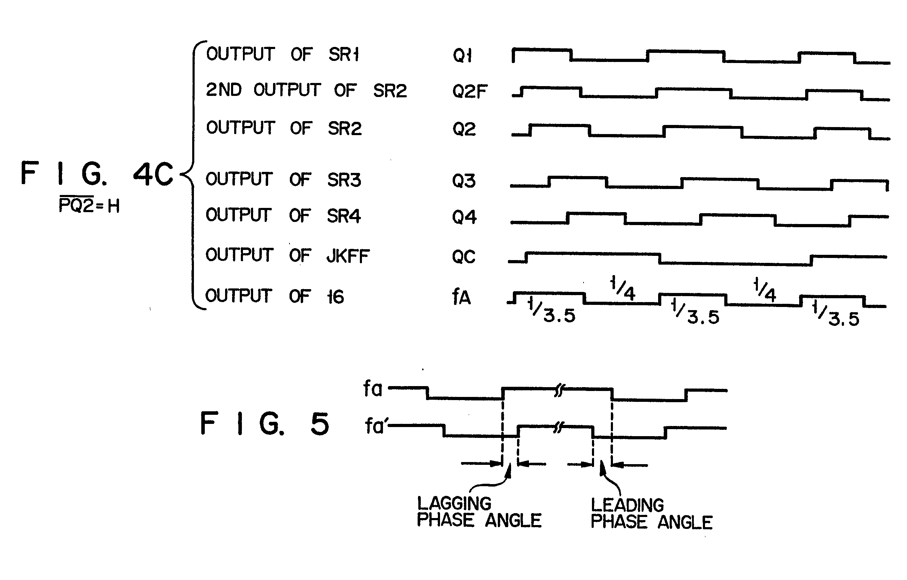

It is assumed that the signal $\overline{PQ_2}$ (output of inverter 49) becomes "H" level as shown in Fig. 4C. The signal $\overline{PH}$ (output of $RSFF_1$) may be either of "H" level or of "L" level. This time, $\overline{J}$ and $\overline{K}$ input terminals of JKFF 24 becomes "L" level, so that the JKFF 24 divides the output $Q_2$ to 1/2 at the time when it rises at the output terminal $Q_2$ of shift register SR2. As described referring to Fig. 4A, the first frequency divider circuit 16 divides the signal $f_s$ to 1/7 when the first output terminal $QC$ of JKFF 24 is of "H" level and to 1/8 when the first output terminal $QC$ is of "L" level, as described referring to Fig. 4B. Therefore, what signal at the output terminal $Q_2$ of shift register SR2 is divided to 1/2 as shown in Fig. 4C means that the output signal $f_A$ of first frequency divider circuit 16 becomes a signal having a frequency in which the output signal of VCO 15 is divided to 1/7.5. As described referring to Figs. 4A—4C, the frequency dividing ratio of first divider circuit 16 is controlled according to levels of signals $\overline{PQ_2}$ and $\overline{PH}$, which is apparent from the following table.

TABLE

| Level of $PQ_2$ (Inverter 49) | Level of PH (RSFF$_1$) | Output QC of JKFF 24 | Dividing ratio of divider 16 |
|---|---|---|---|
| H | H or L | $Q_2$ of SR2 is divided to 1/2 | 1/7.5 |
| L | H | L | 1/8 |
| L | L | H | 1/7 |

As described above, rising phases of first and second clock signals $f_a'$ and $f_a$ are detected and the frequency dividing ratio of first frequency divider circuit 16 is controlled according to the phase difference between these clock signals so as to synchronize phases of signals $f_a$ and $f_a'$ immediately. Namely, providing that the frequency dividing ratio of first frequency divider circuit 16 is usually 1/N, the frequency dividing ratio is controlled in such a way that N becomes N, N+1, or

$$\frac{N+(N+1)}{2}=N+0.5,$$

wherein N represents a positive integer. As soon as phase difference is caused between first and second clock signals $f_a'$ and $f_a$, phases of both signals can be immediately synchronized with each other by controlling the frequency dividing ratio of first frequency divider circuit 16 to any of these three modes. To be more concrete, in the case where the phase of first clock signal $f_a'$ is lagged relative to that of second clock signal $f_a$, the frequency dividing ratio of first frequency divider circuit 16 is controlled to 1/7 only one time during one cycle of first clock signal $f_a'$ and then to 1/7.5 during the remaining period of one cycle. In the case where the phase of first clock signal $f_a'$ is advanced relative to that of second clock signal $f_a$, the frequency dividing ratio of first divider circuit 16 is controlled to 1/8 only one time and then to 1/7.5 during the remaining period of one cycle.

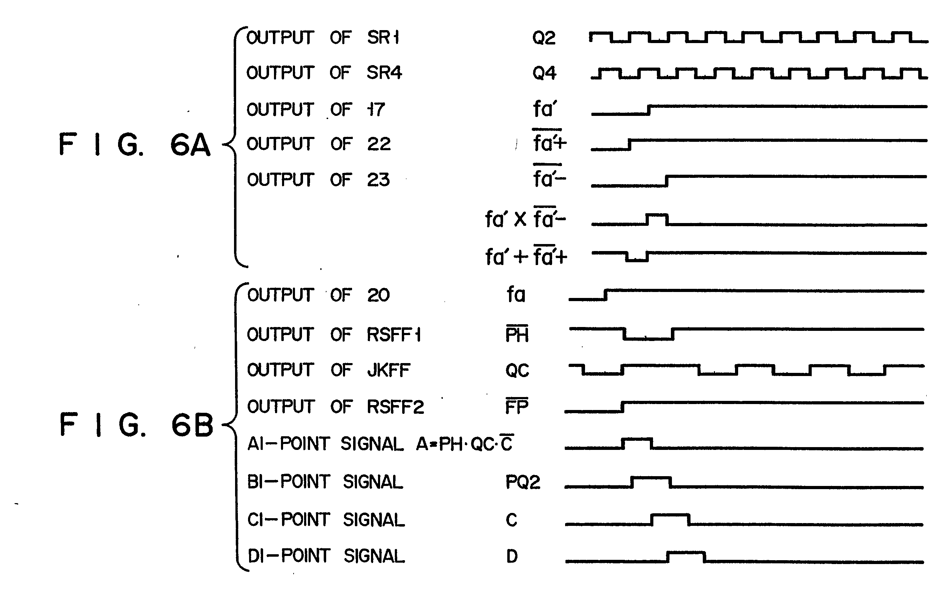

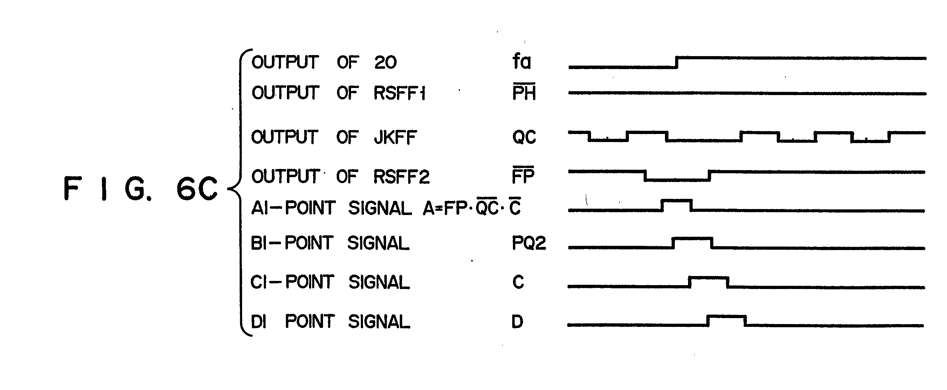

Before operation of second phase comparison circuit 21 shown in Fig. 2 is described, the phase advancing circuit 22 and phase lagging circuit 23 will be described. As shown in Fig. 6A, the phase advancing circuit 22 is intended to produce the signal $\overline{f_a'}_+$ which corresponds to the output signal of second divider circuit 17 or first clock signal $f_a'$ which has been advanced in phase only by half cycle of output pulse from the output terminal $Q_2$ of shift register SR2. As shown in Fig. 6A, the phase lagging circuit 23 is intended to produce the signal $\overline{f_a'}_-$ corresponding to the first clock signal $f_a'$ which has been lagged in phase only by half cycle of output pulse from the output terminal $Q_2$. These signals $\overline{f_a'}_+$ and $\overline{f_a'}_-$ are used in the second phase comparison circuit 21 to produce pulses of narrow width before and after the first clock signal $f_a'$ rises. Namely, signals $\overline{f_a'}_+$ and $\overline{f_a'}_-$ are used to obtain the output of AND gate 39, which receives, as inputs $f_a'$, $\overline{f_a'}_-$ and $\overline{f_a}$ (inverted signal of $f_a$), and the output of OR gate 40, which receives, as inputs, $\overline{f_a'}_+$, $f_a'$ and $\overline{f_a}$. To be more concrete, in the case where $f_a'$ is lagged relative to $f_a$, the output $\overline{PH}$ of RSFF₁ becomes "L" level, as shown in Fig. 6B, due to the output (or output of OR gate 40) which corresponds to the logical sum of signals $\overline{f_a'}_+$, $f_a'$ and $\overline{f_a}$, and the output $\overline{FP}$ of RSFF₂ becomes "H" level at the same time. It is now assumed to make the description simpler that the output line of NAND gate 45 is represented by Al, Q output terminal of shift register 25 Bl, Q output line of shift register 26 Dl and QF output line of shift register 26 Cl and that signals at output lines A1, B1, C1 and D1 are represented by A, $\overline{A}$; B, $\overline{B}$; C, $\overline{C}$ and D, $\overline{D}$, respectively. In the case where the second clock signal $f_a$ is advanced relative to the first clock signal $f_a'$ (see Fig. 6B), the output of OR gate 40 becomes $f_a' + \overline{f_a'}_+$ causing the output $\overline{PH}$ of RSFF₁ to be made of "L" level. When the $\overline{QC}$ output of JKFF 24 becomes "L", the level at point A1 becomes "H" and the level at line B1 "H", thus causing the RSFF₁ to be reset. The first frequency divider circuit 16 divides the output signal $f_s$ of VCO 15 to 1/7 during the period when the line B1 is "H", $\overline{PQ}$="L" and $\overline{PH}$="L". As the result, first and second clock signals $f_a'$ and $f_a$ can be synchronized in phase.

Let us consider now the case where the phase of first clock signal $f_a'$ is advanced relative to that of second clock signal $f_a$. The RSFF₂ is set by applying to the NOR gate 47 of RSFF₂ the output of AND gate 39 which serves to obtain the logical product of signals $f_a'$, $\overline{f_a'}_-$ and $\overline{f_a}$, and the output $\overline{FP}$ of this RSFF₂ becomes "L" level. Therefore, the output $\overline{PQ_2}$ of inverter 49 becomes "L" level and the output $\overline{PH}$ of RSFF₁ "H" level. As apparent from the above-mentioned table, the first frequency divider circuit can be operated so as to divide the frequency of the output signal $f_s$ of VCO 15 to 1/8. As the result, first and second clock signals $f_a'$ and $f_a$ can be synchronized in phase.

According to the embodiment of the present invention as described above, pulses of narrow width are generated through the OR gate 40 and AND gate 39 before and after the first clock signal $f_a'$ rises, and the time when the second clock signal $f_a$ rises is detected by these pulses of narrow width. Even if noise is added to the second clock signal $f_a$ because of wiring arrangement, no influence is given to the synchronizing operation of first and second clock signals as long as noise is not added to the second clock signal $f_a$ during the period when pulses of narrow width are generated.

The embodiment of the present invention shown in Fig. 1 is intended to separate vertical synchronizing signal from video signal, for example, by means of synchronizing signal separation circuit 12, and second, third and fifth frequency divider circuits 17, 18 and 20 are therefore arranged in addition to first and fourth divider circuits 16 and 19. However, second, third and fifth divider circuits may be omitted depending upon the frequency of input signal of first phase comparison circuit. In this case, the first frequency divider circuit 16 can be used as first frequency dividing means, and the fourth frequency divider circuit as second frequency dividing means. Therefore, the output of first frequency divider circuit 16 can be used as first clock signal and the output of fourth frequency divider circuit 19 as second clock signal.

It should be understood that the present invention is not limited to the embodiment as described above. It is not necessary to limit first and second clock signals $f_a'$ and $f_a$ applicable only to reproducing and recording sections as in the case where digital data are reproduced and reproduced data are recorded on a new recording medium.

### Claims

1. A phase synchronizing circuit for obtaining first ($f_a'$) and second clock signals ($f_a$) whose phases are synchronized with each other provided with a phase locked loop including a first phase comparison circuit (13), a voltage controlled oscillator (VCO) (15) for producing an oscillation output the frequency of which is controlled by the output of said first phase comparison circuit, first frequency dividing means (16, 17) having at least a first frequency divider (16) to divide the frequency of oscillation output of said VCO wherein a predetermined input signal is supplied to said first phase comparison circuit and second frequency dividing means (19, 20) for dividing the output frequency ($f_s$) of said VCO (15), characterized in that said phase synchronizing circuit further includes a second phase comparison circuit (21) for receiving, as inputs, the first clock signal ($f_a'$) which is an output from said first frequency dividing means and said second clock signal ($f_a$) which is an output from said second frequency dividing means, to compare phases of said first and second clock signals; and frequency dividing ratio controlling means for controlling said first frequency divider (16) and second phase comparison circuit (21) in such a way that the frequency dividing ratio of said first divider (16) is changed to one of three stages of 1/N, 1/(N+1) and 1/{[N+(N+1)]/2} (wherein N is a positive integer) according to the phase difference between said first and second clock signals so as to synchronize phases of said first and second clock signals.

2. A phase synchronizing circuit according to claim 1 characterized in that said frequency dividing ratio controlling means includes a phase advancing circuit (22) for generating a phase-advancing signal ($\overline{f_a'}_+$) which leads said first clock signal ($f_a'$) by a predetermined angle; and a phase lagging circuit (23) for generating a phase-lagging signal ($\overline{f_a'}_-$) which lags from said first clock signal by the predetermined angle, and that said phase-advancing and phase-lagging signals are supplied to said second phase comparison circuit (21) as signals for detecting the leading edge of said second clock signal ($f_a$).

## Patentansprüche

1. Phasensynchronisierschaltung zum Erhalten eines ersten (fa') und eines zweiten Taktsignals (fa), deren Phasen miteinander synchronisiert sind, umfassend eine Phasenregelschleife mit einer ersten Phasenvergleichsschaltung (13), einem spannungsgesteuerten Oszillator (VCO) (15) zum Erzeugen eines Schwingungsausgangssignals, dessen Frequenz durch das Ausgangssignal der ersten Phasenvergleichsschaltung gesteuert wird, einer ersten Frequenz-teilereinrichtung (16, 17) mit wenigstens einem ersten Frequenzteiler (16) zum Teilen der Frequenz des Schwingungsausgangssignals des VCO, wobei ein vorbestimmtes Eingangssignal an die erste Phasenvergleichsschaltung geliefert wird, und einer zweiten Frequenzteilereinrichtung (19, 20) zum Teilen der Ausgangsfrequenz ($f_a$) des VCO (15), dadurch gekennzeichnet, daß die Phasensynchronisierschaltung außerdem eine zweite Phasenvergleichsschaltung (21) aufweist, die als Eingangssignale das erste Taktsignal ($f_a'$), das von der ersten Frequenzteilereinrichtung audgegeben wird, und das zweite Taktsignal ($f_a$), welches ein Ausgangssignal der zweiten Frequenzteilereinrichtung ist, empfängt, um die Phasen des ersten und des zweiten Taktsignals zu vergleichen, une eine Frequenzteilungsverhältnis-Steuerschaltung aufweist zum Steuern des ersten Frequenzteilers (16) und der zweiten Phasenvergleichsschaltung (21) derart, daß das Frequenzteilungsverhältnis des ersten Teilers (16) in einen der drei Zustände 1/N, 1/(N+1) und 1/{[N+(N+1)]/2} (wobei N eine natürliche Zahl ist) nach Maßgabe der Phasendifferenz zwischen dem ersten und dem zweiten Taktsignal geändert wird, um die Phasen des ersten und des zweiten Taktsignals zu synchronisieren.

2. Phasensynchronisierschaltung nach Anspruch 1, dadurch gekennzeichnet, daß die Frequenzteilungsverhältnis-Steuereinrichtung eine Phasenvorrückschaltung (22) zum Erzeugen eines Phasenvorrücksignals ($\overline{f_a'_+}$), die dem ersten Taktsignal ($f_a'$) mit einem vorbestimmten Winkel voreilt, aufweist, und eine Phasennacheilschaltung (23) aufweist sum Erzeugen eines Phasennacheilsignals ($\overline{f_a'_-}$), welches dem ersten Taktsignal um einen vorbestimmten Winkel nacheilt, und daß die Phasenvorrück- und Phasennacheil-Signale der zweiten Phasenvergleichsschaltung (21) als Signale zum Erfassen der Vorderflanke des zweiten Taktsignals ($f_a$) zugeführt werden.

## Revendications

1. Circuit de synchronisation de phase pour obtenir des premier ($f_a'$) et second ($f_a$) signaux d'horloge dont les phases sont synchronisées entre elles qui est pourvu d'une boucle à blocage de phase incluant un premier circuit de comparaison de phases (13), un oscillateur à fréquence réglée par variation de tension (VCO) (15) pour produire un signal de sortie d'oscillation dont la fréquence est réglée par le signal de sortie du premier circuit de comparaison de phases, un premier moyen de division de fréquence (16, 17) comportant au moins un premier diviseur de fréquence (16) pour diviser la fréquence du signal de sortie d'oscillation de l'oscillateur VCO, dans lequel un signal d'entrée prédéterminé est envoyé au premier circuit de comparaison de phases, et un second moyen de division de fréquence (19, 20) pour diviser la fréquence de signal de sortie ($f_s$) de l'oscillateur VCO (15), caractérisé en ce que le circuit de synchronisation de phase comprend en outre un second circuit de comparaison de phases (21) pour recevoir, comme signaux d'entrée, le premier signal d'horloge ($f_a'$) qui est une signal de sortie du premier moyen de division de fréquence et le second signal d'horloge ($f_a$) qui est un signal de sortie du second moyen de division de fréquence, et pour comparer les phases des premier et second signaux d'horloge; et un moyen de réglage de rapport de division de fréquence pour commander le premier diviseur de fréquence (16) et le second circuit de comparaison de phases (21) de manière à ce que le rapport de division de fréquence du premier diviseur (16) soit changé en l'un des trois paliers 1/N, 1/(N+1) et 1/{[N+(N+1)]/2} (où N est une entier positif) conformément à la différence de phase entre le premier et le second signal d'horloge de manière à synchroniser les phases des premier et second signaux d'horloge.

2. Circuit de synchronisation de phase selon la revendication 1, caractérisé en ce que le moyen de réglage de rapport de division de fréquence comprend un circuit de décalage de phase en avant (22) pour engendrer un signal de décalage de phase en avant ($\overline{f_a'_+}$) qui décale en avant le premier signal d'horloge ($f_a'$) d'un angle prédéterminé; et un circuit de décalage de phase en arrière (23) engendrer un signal de décalage de phase en arrière ($\overline{f_a'_-}$) qui décale en arrière le premier signal d'horloge de l'ange prédéterminé, et en ce que ces signaux de décalage de phase en avant et an arrière sont envoyés au second circuit de comparaison de phases (21) comme des signaux destinés à la détection du bord avant du second signal d'horloge ($f_a$).

F I G. 1

# 0 056 128

# F I G. 2

# F I G. 3

2

## F I G. 4A
$\overline{PQ2}=L ; \overline{PH}=L$

| OUTPUT OF VCO 15 | fS |
| OUTPUT OF SR1 | Q1 |
| OUTPUT OF SR2 | Q2 |
| OUTPUT OF SR3 | Q3 |
| OUTPUT OF SR4 | Q4 |
| OUTPUT OF JKFF | QC |
| OUTPUT OF 16 | fA |

## F I G. 4B
$\overline{PQ2}=L ; \overline{PH}=H$

| OUTPUT OF SR1 | Q1 |
| OUTPUT OF SR2 | Q2 |
| OUTPUT OF SR3 | Q3 |
| OUTPUT OF SR4 | Q4 |
| OUTPUT OF JKFF | QC |
| OUTPUT OF 16 | fA |

# F I G. 4C

$\overline{PQ2}$ = H

| OUTPUT OF SR1 | Q1 |
| 2ND OUTPUT OF SR2 | Q2F |
| OUTPUT OF SR2 | Q2 |
| OUTPUT OF SR3 | Q3 |
| OUTPUT OF SR4 | Q4 |
| OUTPUT OF JKFF | QC |
| OUTPUT OF 16 | fA |

$\frac{1}{4}$     $\frac{1}{4}$

$\frac{1}{3.5}$    $\frac{1}{3.5}$    $\frac{1}{3.5}$

# F I G. 5

fa

fa′

LAGGING
PHASE ANGLE

LEADING
PHASE ANGLE

F I G. 6A

OUTPUT OF SR1    Q2

OUTPUT OF SR4    Q4

OUTPUT OF 17    $fa'$

OUTPUT OF 22    $\overline{fa'+}$

OUTPUT OF 23    $\overline{fa'-}$

$fa' \times \overline{fa'-}$

$fa' + \overline{fa'+}$

F I G. 6B

OUTPUT OF 20    fa

OUTPUT OF RSFF1    $\overline{PH}$

OUTPUT OF JKFF    QC

OUTPUT OF RSFF2    $\overline{FP}$

AI-POINT SIGNAL A=PH·QC·$\overline{C}$

BI-POINT SIGNAL    PQ2

CI-POINT SIGNAL    C

DI-POINT SIGNAL    D

0 056 128

F I G. 6C

| | |
|---|---|
| OUTPUT OF 20 | fa |
| OUTPUT OF RSFF1 | $\overline{PH}$ |
| OUTPUT OF JKFF | QC |
| OUTPUT OF RSFF2 | $\overline{FP}$ |
| AI-POINT SIGNAL $A = FP \cdot \overline{QC} \cdot \overline{C}$ | |
| BI-POINT SIGNAL | PQ2 |
| CI-POINT SIGNAL | C |
| DI POINT SIGNAL | D |

0 056 128